(19) Europäisches Patentamt
European Patent Office
Office européen des brevets

(11) **EP 1 850 397 B1**

(12) **EUROPEAN PATENT SPECIFICATION**

(45) Date of publication and mention
of the grant of the patent:
**19.12.2012 Bulletin 2012/51**

(51) Int Cl.:
*H01L 31/0224* (2006.01)   *H01L 31/18* (2006.01)
*H01L 31/04* (2006.01)

(21) Application number: **06713280.3**

(22) Date of filing: **08.02.2006**

(86) International application number:
**PCT/JP2006/302137**

(87) International publication number:
**WO 2006/085543 (17.08.2006 Gazette 2006/33)**

(54) **Photovoltaic device, photovoltaic module comprising photovoltaic device, and method for manufacturing photovoltaic device**

Fotovoltaische Einrichtung, fotovoltaisches Modul mit fotovoltaischer Einrichtung und Verfahren zur Herstellung einer fotovoltaischen Hinrichtung

Dispositif photovoltaïque, module photovoltaïque comprenant ledit dispositif et procédé pour fabriquer ledit dispositif

(84) Designated Contracting States:
**AT BE BG CH CY CZ DE DK EE ES FI FR GB GR HU IE IS IT LI LT LU LV MC NL PL PT RO SE SI SK TR**

(30) Priority: **14.02.2005 JP 2005035336**

(43) Date of publication of application:
**31.10.2007 Bulletin 2007/44**

(73) Proprietor: **Sanyo Electric Co., Ltd.**
**Osaka 570-8677 (JP)**

(72) Inventors:
• **NAKASHIMA, Takeshi**
**006 (JP)**

• **MARUYAMA, Eiji**
**Osaka, 5760021 (JP)**

(74) Representative: **Calderbank, Thomas Roger et al**
**Mewburn Ellis LLP**
**33 Gutter Lane**
**London**
**EC2V 8AS (GB)**

(56) References cited:
**JP-A- 02 143 569      JP-A- 06 204 541**
**JP-A- 06 204 544      JP-A- 07 326 784**
**JP-A- 2000 294 812    JP-A- 2001 156 317**

**Description**

The present invention relates to a photovoltaic device, a photovoltaic module comprising the photovoltaic device, and a method for manufacturing the photovoltaic device, and more particularly, it relates to a photovoltaic device comprising a semiconductor layer including a photoelectric conversion layer, a photovoltaic module comprising the photovoltaic device, and a method for manufacturing the photovoltaic device.

Background Art

In a photovoltaic device comprising a semiconductor layer including a photoelectric conversion layer, various proposals for improving photoelectric conversion efficiency have been made in general. Such a photovoltaic device is disclosed in Japanese Patent Laying-Open No. 51-117591 (1976), for example.

The aforementioned Japanese Patent Laying-Open No. 51-117591 discloses a photoelectric conversion element (photovoltaic device) comprising a lower electrode, an n-type semiconductor layer formed on the lower electrode, a p-type semiconductor layer formed on the n-type semiconductor layer, a porous p-type semiconductor layer formed on the p-type semiconductor layer, an upper electrode (transparent electrode) consisting of Cr so formed as to cover an upper surface of the porous p-type semiconductor layer. In this Japanese Patent Laying-Open No. 51-117591, the porous p-type semiconductor layer is arranged on an incidence side, whereby reflection of incident light is suppressed by holes of the porous p-type semiconductor layer, and an surface area of a light-receiving surface is increased by holes of the porous p-type semiconductor layer, thereby suppressing reduce in the incident light. Thus, the photoelectric conversion efficiency is improved.

In the photoelectric conversion element disclosed in the aforementioned Japanese Patent Laying-Open No. 51-117591, however, the porous p-type semiconductor layer is arranged on the incidence side, whereby the incident light is likely to diffuse inside the porous p-type semiconductor layer. In this case, the light pass length of the light in the porous p-type semiconductor layer is increased, whereby light incident is likely to be absorbed in the porous p-type semiconductor layer. Consequently, the quantity of light reaching a p-n junction portion is reduced, whereby it is disadvantageously difficult to sufficiently improve the photoelectric conversion efficiency.

JP 06-204544 discloses a solar cell module having a scratch resistant surface protection layer.

JP 06-204541 discloses a photovoltaic device having a light-scattering layer having an indented structure formed in a surface protection layer.

JP 2000-294812 discloses a photoelectric converter element having electrode layers formed with uneven surfaces.

JP 2001-156317 discloses a photovoltaic element having a transparent electrode layer whose specific resistance in a region in contact with a semiconductor layer is smaller than that in other regions.

JP 02-143569 discloses a photoelectric conversion element having a surface rugged layer provided with pyramidal and waved irregularities.

JP 06-116996 discloses a solar battery element having a reflection preventing film with a surface roughened by reactive ion etching.

Disclosure of the Invention

The present invention has been proposed in order to solve the aforementioned problem, and an object of the present invention is to provide a photovoltaic device capable of sufficiently improving photoelectric conversion efficiency, a photovoltaic module comprising the photovoltaic device, and a method for manufacturing the photovoltaic device.

According to a first aspect of the invention, there is provided a photovoltaic device according to claim 1.

In the photovoltaic device according to the first aspect of the present invention, as hereinabove described, the first layer having the first hole extending in the film thickness direction is provided on the light incident side, whereby the light incident upon the first hole can be directed to the side of the photoelectric conversion layer below the first layer through the first hole extending in the film thickness direction and can be diffused to the side of the photoelectric conversion layer below the first layer by light diffraction effect. Thus, the quantity of the light incident upon the photoelectric conversion layer can be increased and the light pass length of the light incident upon the photoelectric conversion layer can be increased by diffusion, whereby photoelectric conversion efficiency can be sufficiently improved. Additionally, the first layer is formed by the translucent material, whereby the diffused light can be inhibited from being absorbed by the first layer, and hence the quantity of light incident upon the photoelectric conversion layer can be increased also for this reason. The first hole extending in the film thickness direction is provided on the light incident side of the first layer, whereby reflectance on the surface of the first layer is reduced as compared with a case where the first hole is not provided, and hence it is possible to make the first layer function as an antireflection film. Also for this reason, the quantity of the light incident upon the photoelectric conversion layer can be increased, whereby the photoelectric conversion efficiency can be further improved.

The aforementioned photovoltaic device according to the first aspect preferably further comprises a collector formed on the semiconductor layer, wherein the first layer is preferably so formed as to cover the collector and preferably constituted by a translucent material having conductivity. According to this structure, it is possible to make the first layer function as an electrode and hence current collection characteristics can be improved.

In the aforementioned photovoltaic device according to the first aspect, the first layer constituted by the translucent material is preferably a ZnO layer having the first hole extending in the film thickness direction. According to this structure, ZnO has a function of absorbing ultraviolet light, whereby the ultraviolet light can be inhibited from being incident upon the collector including an organic material in a case where the collector including the organic material is arranged below the first layer for example. Thus, an organic material portion of the collector can be inhibited from discoloring due to the ultraviolet light.

In the aforementioned photovoltaic device according to the first aspect, a plurality of the first holes of the first layer are provided to penetrate the first layer in the film thickness direction. According to this structure, the light incident upon the first hole is further likely to reach the photoelectric conversion layer and hence the quantity of the light incident upon the photoelectric conversion layer can be further increased.

The aforementioned photovoltaic device according to the first aspect preferably further comprises a second layer constituted by a translucent material, formed on the first layer constituted by the translucent material, and having a second hole on a portion corresponding to the first hole of the first layer, wherein the etching rate of the second layer with respect to prescribed etching solution is preferably smaller than the etching rate of the first layer with respect to the prescribed etching solution. According to this structure, the second hole and the first hole are formed by etching the second layer and the first layer by using the prescribed etching solution, whereby the first hole can be formed on a portion corresponding to the second hole of the second layer in the first layer while inhibiting the second hole formed in the second layer from being too lager than the first hole formed on the first layer when the second hole and the first hole are formed.

In the aforementioned photovoltaic device comprising the second layer, the second layer preferably consists of a Si compound including at least one of O and N. According to this structure, the second layer can be formed by a material having relatively small refractive index such as Si02 and SiON, whereby the light incident upon the second layer can be inhibited from reflecting on the surface of the second layer.

In the aforementioned photovoltaic device comprising the second layer, the first layer having the first hole and the second layer having the second hole preferably function as a diffused layer having a haze rate of at least 10 % and not more than 50 %. According to this structure, the light incident upon the second layer and the first layer can be sufficiently diffused.

In the aforementioned photovoltaic device according to the first aspect, the first hole has an inner diameter of not more than 1.2 $\mu$m. According to this structure, wavelength (not more than about 1.2 $\mu$m) of light photoelectrically converted by the photovoltaic device can be further likely to be diffused by Huygens principle (diffraction effect), whereby light incident upon the first layer can be further diffused.

Also disclosed herein is a photovoltaic module comprising a plurality of photovoltaic devices each including a semiconductor layer including a photoelectric conversion layer and a first layer constituted by a translucent material, formed on the semiconductor layer and having a first hole extending in a film thickness direction on a light incident side, and a tab electrode connecting the plurality of photovoltaic devices each other.

In the photovoltaic module hereinabove described, the first layer having the first hole extending in the film thickness direction is provided on the light incident side, whereby the light incident upon the first hole can be directed to the side of the photoelectric conversion layer below the first layer through the first hole extending in the film thickness direction and can be diffused to the side of the photoelectric conversion layer below the first layer by light diffraction effect. Thus, the quantity of the light incident upon the photoelectric conversion layer can be increased and the light pass length of the light incident upon the photoelectric conversion layer can be increased by diffusion, whereby photoelectric conversion efficiency can be sufficiently improved. Additionally, the first layer is formed by the translucent material, whereby the diffused light can be inhibited from being absorbed by the first layer, and hence the quantity of light incident upon the photoelectric conversion layer can be increased also for this reason. The first hole extending in the film thickness direction is provided on the light incident side of the first layer, whereby reflectance on the surface of the first layer is reduced as compared with a case where the first hole is not provided, and hence it is possible to make the first layer function as an antireflection film. Also for this reason, the quantity of the light incident upon the photoelectric conversion layer can be increased, whereby the photoelectric conversion efficiency can be further improved.

The aforementioned photovoltaic module preferably further comprises a resin layer covering an upper surface of the photovoltaic device, wherein the resin layer is preferably so formed as to enter into at least a part of the first hole provided in the film thickness direction of the first layer constituted by the translucent material. According to this structure, anchor effect can be obtained by the portion where the resin layer enters into the first hole of the first layer, whereby a junction strength between the resin layer and the translucent material can be improved.

According to a second aspect of the invention, there is provided a method for manufacturing a photovoltaic device according to claim 7.

In the method for manufacturing a photovoltaic device according to the second aspect of the present invention, as herein described, the first hole extending in the film thickness direction is formed on the portion corresponding to the crystal grain boundary of the second layer in the first layer, whereby it is possible to easily form the photovoltaic device capable of directing the light incident upon the first hole to the side of the photoelectric conversion layer below the first layer through the first hole extending in the film thickness direction and diffusing the same to the side of the photoelectric conversion layer below the first layer by light diffraction effect. Thus, the quantity of the light incident upon the photoelectric conversion layer can be increased and the light pass length of the light incident upon the photoelectric conversion layer can be increased by diffusion, whereby photoelectric conversion efficiency can be sufficiently improved. Additionally, the first layer is formed by the translucent material, whereby the diffused light can be inhibited from being absorbed by the first layer, and hence the quantity of light incident upon the photoelectric conversion layer can be increased also for this reason. The first hole extending in the film thickness direction is formed in the first layer, whereby reflectance on the surface of the first layer is reduced as compared with a case where the first hole is not provided, and hence it is possible to make the first layer function as an antireflection film. Also for this reason, the quantity of the light incident upon the photoelectric conversion layer can be increased, whereby the photoelectric conversion efficiency can be further improved.

The aforementioned method for manufacturing a photovoltaic device according to the second aspect preferably further comprises a step of forming a collector on the semiconductor layer prior to the step of forming the first layer on the semiconductor layer, wherein the step of forming the first layer on the semiconductor layer preferably includes a step of forming the first layer constituted by a translucent material having conductivity to cover the collector. According to this structure, it is possible to make the first layer function as an electrode and hence current collection characteristics can be improved.

In the aforementioned method for manufacturing a photovoltaic device according to the second aspect, the first layer constituted by the translucent material preferably is a ZnO layer having the first hole extending in the film thickness direction. According to this structure, ZnO has a function of absorbing ultraviolet light, whereby the ultraviolet light can be inhibited from being incident upon the collector including an organic material in a case where the collector including the organic material is arranged below the first layer for example. Thus, an organic material portion of the collector can be inhibited from discoloring due to the ultraviolet light.

In the aforementioned method for manufacturing a photovoltaic device according to the second aspect, the step of forming the first hole and the second hole extending in the film thickness direction preferably includes a step of providing a plurality of the first hole penetrating the first layer in the film thickness direction. According to this structure, the light incident upon the first hole is further likely to reach the photoelectric conversion layer and hence the quantity of the light incident upon the photoelectric conversion layer can be further increased.

In the aforementioned method for manufacturing a photovoltaic device according to the second aspect, the second layer preferably consists of a Si compound including at least one of O and N. According to this structure, the second layer can be formed by a material having relatively small refractive index such as $SiO_2$ and $SiON$, whereby the light incident upon the second layer can be inhibited from reflecting on the surface of the second layer.

In the aforementioned method for manufacturing a photovoltaic device according to the second aspect, the step of forming the first hole and the second hole extending in the film thickness direction preferably includes a step of forming the first layer having the first hole and the second layer having the second hole so as to function as a diffused layer having a haze rate of at least 10 % and not more than 50 %. According to this structure, light incident upon the second layer and the first layer can be sufficiently diffused.

In the aforementioned method for manufacturing a photovoltaic device according to the second aspect, the first hole has an inner diameter of not more than 1.2 $\mu$m. According to this structure, wavelength (not more than about 1.2 $\mu$m) of light photoelectrically converted by the photovoltaic device can be further likely to be diffused by Huygens principle (diffraction effect), whereby light incident upon the first layer can be further diffused.

Brief Description of the Drawings

[Fig. 1] A sectional view showing a structure of a photovoltaic device according to an embodiment of the present invention.

[Fig. 2] A perspective view of a portion around a ZnO layer of the photovoltaic device according to the embodiment shown in Fig. 1.

[Fig. 3] A sectional view showing a structure of a photovoltaic module comprising the photovoltaic devices according to the embodiment shown in Fig. 1.

[Fig. 4] A sectional view for illustrating details of the photovoltaic device according to the embodiment shown in Fig. 1.

[Fig. 5] A diagram for illustrating light diffraction principle.

[Fig. 6] A diagram for illustrating a method for measuring haze rate.

[Fig. 7] A sectional view for illustrating a process of manufacturing the photovoltaic device according to the embodiment shown in Fig. 1.

[Fig. 8] A sectional view for illustrating a process of manufacturing the photovoltaic device according to the embodiment shown in Fig. 1.

[Fig. 9] A sectional view for illustrating a process of manufacturing the photovoltaic device according to the embodiment shown in Fig. 1.

[Fig. 10] A sectional view showing a structure of a photovoltaic device according to conventional comparative example 1.

[Fig. 11] A sectional view showing a structure of a photovoltaic device according to conventional comparative example 2.

[Fig. 12] A sectional view showing a structure of a photovoltaic device according to conventional comparative example 3.

Best Modes for Carrying Out the Invention

An example of the present invention will be hereinafter described with reference to the drawings.

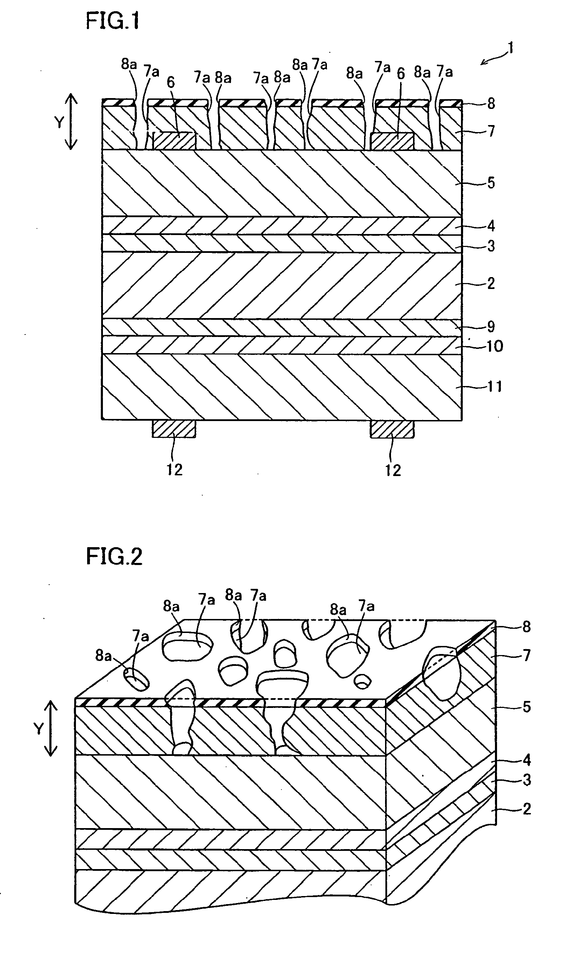

Structures of a photovoltaic device according to an embodiment of the present invention and a photovoltaic module comprising the photovoltaic devices will be now described with reference to Figs. 1 to 6.

In a photovoltaic device 1 according to the embodiment of the present invention, a substantially intrinsic (i-type) amorphous silicon layer 3 is formed on an upper surface of an n-type single-crystalline silicon substrate 2 as shown in Fig. 1. A p-type amorphous silicon layer 4 is formed on the i-type amorphous silicon layer 3. The n-type single-crystalline silicon substrate 2 is an example of the "photoelectric conversion layer" and the "semiconductor layer" in the present invention, and the i-type amorphous silicon layer 3 is an example of the "semiconductor layer" in the present invention. The p-type amorphous silicon layer 4 is an example of the "semiconductor layer" in the present invention.

A transparent conductive film 5 consisting of an ITO (indium tin oxide) film is formed on the p-type amorphous silicon layer 4. A front collector 6 including Ag and an organic material is formed on a prescribed region of an upper surface of the transparent conductive film 5. The front collector 6 is an example of the "collector" in the present invention.

According to this embodiment, a ZnO layer 7, which is a non-doped layer, having a thickness of about 10 nm to about 140 nm is formed on the upper surfaces of the transparent conductive film 5 and the front collector 6. The ZnO layer 7 is an example of the "first layer" in the present invention. A silicon oxide film 8 of $SiO_2$ or the like having a thickness of about 5 nm is formed on an upper surface of the ZnO layer 7. The silicon oxide film 8 is an example of the "second layer" in the present invention. The silicon oxide film 8 is a material having an etching rate with respect to etching solution of HCl (about 0.5 mass %) smaller than the etching rate of the ZnO layer 7.

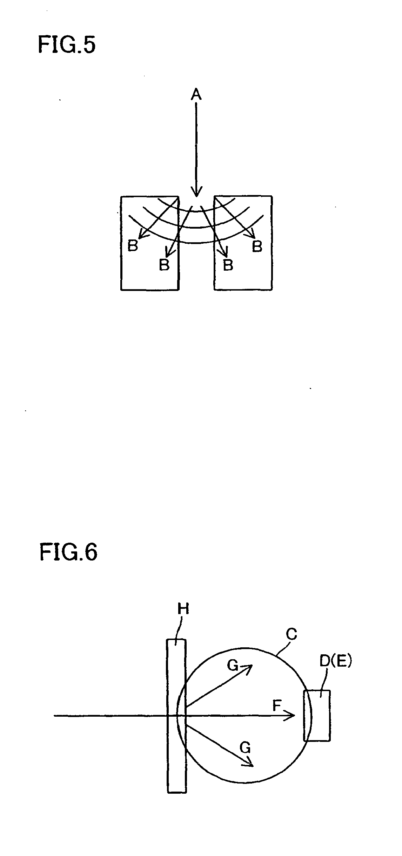

According to this embodiment, a large number of through holes 7a and 8a each having an inner diameter about 0.5 $\mu$m to about 3 $\mu$m extending in a film thickness direction (direction Y in Fig. 1) are formed on prescribed portions of the ZnO layer 7 and the silicon oxide film 8 by wet etching described later, as shown in Figs. 1 and 2. The through hole 7a is an example of the "first hole" in the present invention, and the through hole 8a is an example of the "second hole" in the present invention. Each inner diameter of surfaces of the through holes 7a and 8a is desirably not more than about 1.2 $\mu$m in order to diffuse wavelength(not more than about 1.2 $\mu$m) of light photoelectrically converted with a solar cell by Huygens principle (diffraction effect). As shown in Fig. 5, the Huygens principle (light diffraction effect) is a principle that parallel light incident upon an opening A is diffracted as shown in arrow B. The through holes 7a and 8a are so formed as to be continued in a vertical direction (direction Y in Fig. 1) as shown in Figs. 1 and 2. The ZnO layer 7 and the silicon oxide film 8 each function as a diffused layer having a haze rate of at least about 10 % and not more than about 50 %. The haze rate can be calculated using the following equation (1).

$$\text{haze rate (\%)} = [\text{diffusion light} / (\text{direct reaching light} + \text{diffusion light})] \times 100 \, (\%) \, \ldots \, (1)$$

A TC-HIII of Tokyo Denshoku Co., Ltd. was used as a device measuring the haze rate. More specifically, the device measuring the haze rate is provided with an integrating sphere C provided with a sensor (not shown) on an inner surface thereof, and a reflective plate D or an absorption plate E, as shown in Fig. 6. In a case of measuring sum of the direct reaching light (arrow F) and the diffusion light (arrow G), a sample H and the reflective plate D are mounted on the integrating sphere C. Then, the direct reaching light (arrow F) having transmitted through the sample H is reflected to an inner surface of the integrating sphere C by the reflective plate D and the diffusion light (arrow G) having transmitted through the sample H is incident upon the inner surface of the integrating sphere C. The sum of direct reaching light (arrow F) and diffusion light (arrow G) having transmitted the sample H is measured with the sensor provided on the inner surface of the integrating sphere C. In a case of obtaining the diffusion light (arrow G), the absorption plate E is mounted on the integrating sphere C in a place of the reflective plate D. Then, the direct reaching light (arrow F) having transmitted through the sample H is absorbed in the absorption plate E, whereby the diffusion light (arrow G) having transmitted through sample H is only measured.

As is apparent from the aforementioned equation (1), the greater the quantity of the diffusing light, the greater the haze rate (%).

As shown in Fig. 1, a substantially intrinsic (i-type) amorphous silicon layer 9 and an n-type amorphous silicon layer 10 are formed on an lower surface of the n-type single-crystalline silicon substrate 2 in this order. The i-type amorphous silicon layer 9 is an example of the "semiconductor layer" in the present invention, and the n-type amorphous silicon layer 10 is an example of the "semiconductor layer" in the present invention. A transparent conductive film 11 consisting of an ITO film is formed on a lower surface of the n-type amorphous silicon layer 10. A back collector 12 including Ag and an organic material is formed on a prescribed region of a lower surface of the transparent conductive film 11.

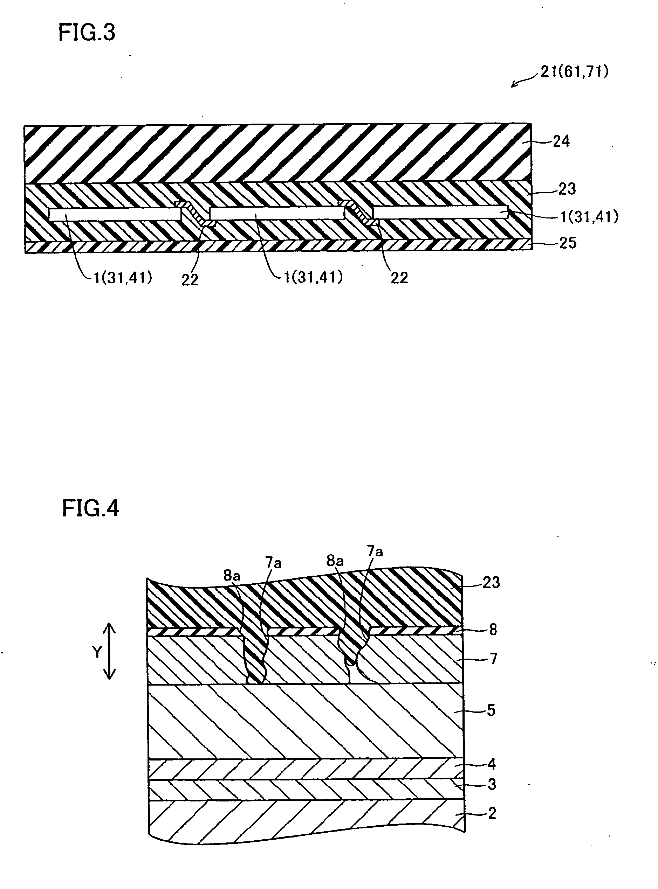

As shown in Fig. 3, a photovoltaic module 21 according to this embodiment includes a plurality of the photovoltaic devices 1. Each of the plurality of photovoltaic devices 1 is connected to the adjacent photovoltaic device 1 through a tab electrode 22 of copper foil. The plurality of photovoltaic devices 1 connected through the tab electrodes 22 are covered with a filler 23 consisting of EVA (ethylene vinyl acetate). The filler 23 is an example of the "resin layer" in the present invention.

According to this embodiment, the filler 23 of EVA penetrates the through holes 7a and 8a of the ZnO layer 7 and the silicon oxide film 8 as shown in Fig. 4. A front surface protector 24 of a glass substrate is provided on an upper surface of the filler 23 as shown in Fig. 3. A back surface protector 25 consisting of PVF (poly vinyl fluoride) having a thickness of about 25 $\mu$m is provided on an lower surface of the filler 23.

According to this embodiment, as hereinabove described, the ZnO layer 7 having the through holes 7a extending in the film thickness direction (direction Y in Fig. 1) is provided on the light incident side, whereby the light incident upon the through holes 7a of the ZnO layer 7 can be directed to the side of the n-type single-crystalline silicon substrate 2 below the ZnO layer 7 through the through holes 7a extending in the film thickness direction and can be diffused to the side of the n-type single-crystalline silicon substrate 2 below the ZnO layer 7 by light diffraction effect. Thus, the quantity of the light incident upon the n-type single-crystalline silicon substrate 2 can be increased and the light pass length of the light incident upon the n-type single-crystalline silicon substrate 2 can be increased by diffusion, whereby photoelectric conversion efficiency can be sufficiently improved. Additionally, the ZnO layer 7 is a translucent material and the diffused light can be inhibited from being absorbed by the ZnO layer 7, and hence the quantity of light incident upon the n-type single-crystalline silicon substrate 2 can be increased also for this reason. The through holes 7a extending in the film thickness direction is provided on the side on which the light of the ZnO layer 7 is incident, whereby reflectance on the surface of the ZnO layer 7 is reduced as compared with a case where the through holes 7a is not provided, and hence it is possible to make the ZnO layer 7 function as an antireflection film. Also for this reason, the quantity of the light incident upon the n-type single-crystalline silicon substrate 2 can be increased, whereby the photoelectric conversion efficiency can be further improved.

According to this embodiment, the ZnO layer 7 is so formed as to cover the front collector 6 and is formed by the translucent material having conductivity, whereby it is possible to make the ZnO layer 7 function as an electrode and hence current collection characteristics can be improved.

According to this embodiment, the ZnO layer 7 of ZnO is formed on the light incident side, whereby ultraviolet light can be inhibited from being incident upon the front collector 6 and the back collector 12 including organic materials below the ZnO layer 7 since ZnO has a function of absorbing the ultraviolet light. Thus, organic material portions of the front collector 6 and the back collector 12 can be inhibited from discoloring due to the ultraviolet light.

According to this embodiment, the plurality of through holes 7a penetrating in the film thickness direction are provided in the ZnO layer 7, whereby the light incident upon the through holes 7a of the ZnO layer 7 is further likely to reach the n-type single-crystalline silicon substrate 2 and hence the quantity of the light incident upon the n-type single-crystalline silicon substrate 2 can be increased.

According to this embodiment, the silicon oxide film 8 having the etching rate smaller than the etching rate of the ZnO layer 7 with respect to the etching solution (HCl (about 0.5 mass %)) is formed on the upper surface of the ZnO layer 7, whereby the through holes 7a can be formed on portions corresponding to the through holes 8a of the silicon oxide film 8 of the ZnO layer 7 while inhibiting the through holes 8a formed in the silicon oxide film 8 from being too lager than the through holes 7a formed on the ZnO layer 7 when the through holes 8a and 7a are formed by etching the silicon oxide film 8 and the ZnO layer 7 by using the etching solution (HCl (about 0.5 mass %)).

According to this embodiment, the silicon oxide film 8 having relatively small refractive index such as $SiO_2$ is used on the surface upon which light is incident, whereby the light incident upon the silicon oxide film 8 can be inhibited from reflecting on the surface of the silicon oxide film 8.

According to this embodiment, the ZnO layer 7 having the through holes 7a and the silicon oxide film 8 having the through holes 8a are made function as diffused layers each having a haze rate of at least about 10 % and not more than about 50 %, whereby the light incident upon the silicon oxide film 8 and the ZnO layer 7 can be sufficiently diffused.

According to this embodiment, the filler 23 enters into the through holes 7a provided in the film thickness direction of the ZnO layer 7, whereby anchor effect by the through holes 7a of the ZnO layer 7 can be increased. Thus, a junction strength between the filler 23 and the photovoltaic device 1 can be improved.

A process of manufacturing the photovoltaic device 1 according to the embodiment and the photovoltaic module 21 including the photovoltaic device 1 will be now described with reference to Figs. 1, 3, 4 and 7 to 9.

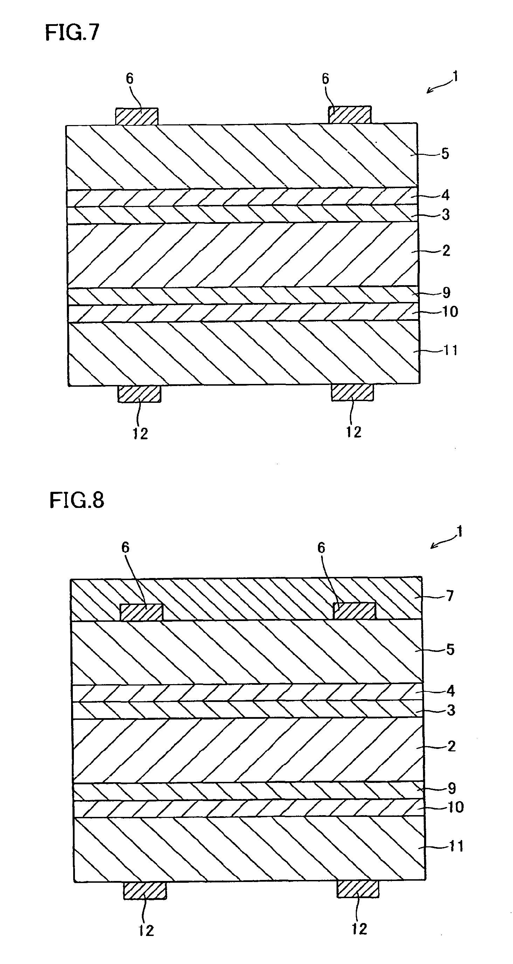

When the photovoltaic device 1 shown in Fig. 1 is prepared, the n-type single-crystalline silicon substrate 2 is first cleaned, thereby removing impurities. Then, as shown in Fig. 7, the i-type amorphous silicon layer 3 and the p-type amorphous silicon layer 4 are successively on the n-type single-crystalline silicon substrate 2 by RF plasma CVD (chemical vapor deposition). Thereafter the i-type amorphous silicon layer 9 and the n-type amorphous silicon layer 10 are successively formed on the lower surface of the n-type single-crystalline silicon substrate 2 by RF plasma CVD. Conditions for forming these i-type amorphous silicon layer 3, p-type amorphous silicon layer 4, i-type amorphous silicon layer 9 and n-type amorphous silicon layer 10 are shown in the following table 1.

Table 1

| Process | | Forming Condition | | |
|---|---|---|---|---|
| | | Gas Flow Rate | Pressure (Pa) | RF Power (W) |
| Front Surface Side | i-type Amorphous Silicon Layer | $H_2$: 100 sccm | 20 | 150 |
| | | $SiH_4$: 40 sccm | | |
| | p-type Amorphous Silicon Layer | $H_2$: 40 sccm | 20 | 150 |
| | | $SiH_4$: 40 sccm | | |
| | | $B_2H_6$(2%): 20sccm | | |
| Back Surface Side | i-type Amorphous Silicon Layer | $H_2$: 100 sccm | 20 | 150 |
| | | $SiH_4$: 40 sccm | | |
| | n-type Amorphous Silicon Layer | $H_2$: 40 sccm | 20 | 150 |
| | | $SiH_4$: 40 sccm | | |
| | | $PH_3$(1%): 40sccm | | |

With reference to the aforementioned table 1, the reaction stress and the RF power for forming the i-type amorphous silicon layer 3 are set to 20 Pa and 150 W respectively. The gas flow rate for forming the i-type amorphous silicon layer 3 is set to $H_2$: 100 sccm and $SiH_4$: 40sccm. The reaction stress and the RF power for forming the p-type amorphous silicon layer 4 are set to 20 Pa and 150 W respectively. The gas flow rate for forming the p-type amorphous silicon layer 4 is set to $H_2$: 40 sccm, $SiH_4$: 40 sccm, and $B_2H_6$ (2%: $H_2$ dilution): 20 sccm.

The reaction stress and the RF power for forming the i-type amorphous silicon layer 9 are set to 20 Pa and 150 W respectively. The gas flow rate for forming the i-type amorphous silicon layer 9 are set to $H_2$: 100 sccm and $SiH_4$: 40 sccm. The reaction stress and the RF power for forming the n-type amorphous silicon layer 10 are set to 20 Pa and 150 W respectively. The gas flow rate for forming the n-type amorphous silicon layer 10 are set to $H_2$: 40 sccm, $SiH_4$: 40 sccm, and $PH_3$ (1%: $H_2$ dilution): 40 sccm.

The transparent conductive film 5 consisting of the ITO film is formed on the p-type amorphous silicon layer 4 by sputtering. Then the transparent conductive film 11 consisting of the ITO film is formed on the lower surface of the n-type amorphous silicon layer 10 by sputtering. Thereafter the front collector 6 including Ag and the organic material is formed on the prescribed region on the upper surface of the transparent conductive film 5 by screen printing. The back collector 12 including Ag and the organic material is formed on the prescribed region on the lower surface of the transparent conductive film 11 by screen printing.

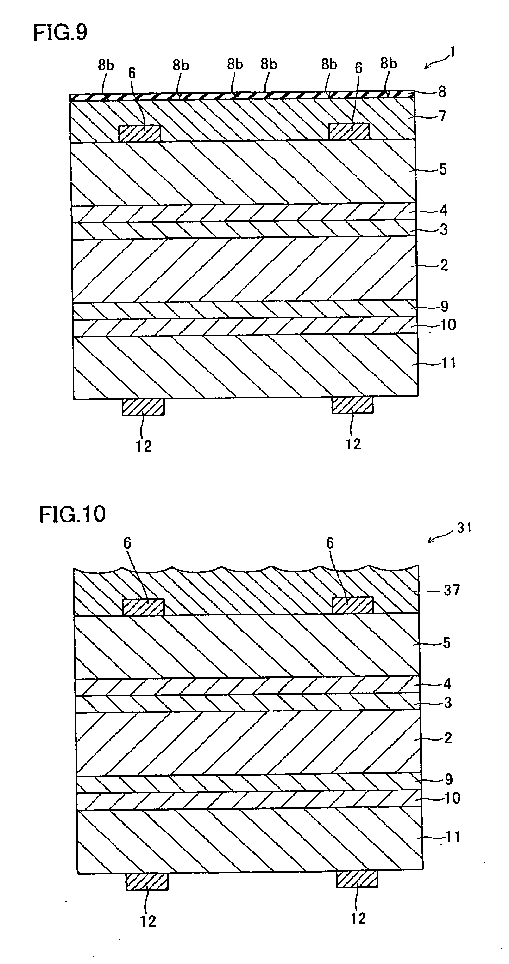

According to this embodiment, as shown in Fig. 8, the ZnO layer 7 having a thickness of about 10 nm to about 140 nm is formed at room temperature by sputtering to cover the transparent conductive film 5 and the front collector 6. As shown in Fig. 9, the silicon oxide film 8 having a thickness of about 5nm is formed by sputtering to cover the upper surface of the ZnO layer 7. At this time, a large number of crystal grain boundaries 8b are formed in the silicon oxide film 8. Then wet etching is performed by immersing it in the etching solution (HCl (about 0.5 mass %)) for about 10 sec, whereby a large number of the through holes 7a and 8a each having an inner diameter of about 0.5 $\mu$m to about 3 $\mu$m, extending in the film thickness direction (direction Y in Fig. 1) are formed in the ZnO layer 7 and the silicon oxide film 8 as shown in Fig. 1. It is considered that the ZnO layer 7 and the silicon oxide film 8 are etched by the HCl (about 0.5 mass %) since the HCl (about 0.5 mass %) penetrates from the crystal grain boundaries 8b of the silicon oxide film 8, the ZnO layer 7 is etched, and the silicon oxide film 8 is removed. Thus, the photovoltaic device 1 according to the embodiment shown in Fig. 1 is formed in the aforementioned manner.

When the photovoltaic module 21 using the photovoltaic device 1 according to this embodiment is formed, the plurality of photovoltaic devices 1 adjacent to each other are connected through the tab electrodes 22 of copper foil as shown in Fig. 3. Then an EVA sheet for forming the filler 23, the plurality of photovoltaic devices 1 connected through the tab electrodes 22, another EVA sheet for forming the filler 23, and the back surface protector 25 consisting of PVF having a thickness of about 25 $\mu$m are successively stacked on the front surface protector 24 consisting of the glass substrate. Thereafter the photovoltaic module 21 using the photovoltaic devices 1 according to this embodiment is formed by performing a vacuum laminating process while heating. At this time, according to this embodiment, a large number of the through holes 7a and 8a are formed in the ZnO layer 7 and the silicon oxide film 8 as shown in Fig. 4, whereby the filler 23 enters into the large number of through holes 7a and 8a of the ZnO layer 7 and the silicon oxide film 8 as shown in Fig. 4

An experiment conducted for confirming the effect of the aforementioned embodiment will be now described. First, the photoelectric conversion efficiency of the photovoltaic device 1 according to the embodiment will be described. In this experiment, the photovoltaic device 1 according to an Example 1 corresponding to the embodiment, and photovoltaic devices 31, 41 and 51 according to comparative examples 1 to 3 were prepared.

(Example 1)

In this Example 1, formation was conducted until the back collector 12 of the photovoltaic device 1 shown in Fig. 1 was formed through the aforementioned process of the embodiment. At this time, the transparent conductive film 5 is formed with a thickness of about 50 nm. Thereafter a ZnO layer 7 having a thickness of about 50 nm is formed at room temperature by sputtering to cover the transparent conductive film 5 and the front collector 6. Then, a silicon oxide film 8 having a thickness of about 5 nm is formed by sputtering to cover the upper surface of the ZnO layer 7. Then wet etching is performed by immersing it in an etching solution (HCl (about 0.5 mass %)) for about 10 sec, whereby a large number of through holes 7a and 8a extending in a film thickness direction are formed in the ZnO layer 7 and the silicon oxide film. Thus, the photovoltaic device 1 according to Example 1 is prepared.

(comparative example 1)

In this comparative example 1, formation was conducted until a back collector 12 of a photovoltaic device 31 shown in Fig. 10 was formed through a process similar to the process of the aforementioned embodiment. At this time, a transparent conductive film 5 is formed with a thickness of about 50 nm. Thereafter a ZnO layer 37 having a thickness of about 50 nm is formed under a temperature condition of 180°C by sputtering to cover the transparent conductive film 5 and front collector 6. Then wet etching is performed by immersing it in an etching solution (HCl (about 0.5 mass %)) for about 20 sec, whereby the ZnO layer 37 having a crater shaped surface for diffusing light is so formed as to have a thickness of about 50 nm. Thus, the photovoltaic device 31 according to comparative example 1 was prepared. The formation temperature of the ZnO layer 37 was set to 180°C since the ZnO layer 37 is required to have a high crystallinity in order to form the surface of the ZnO layer 37 in a crater shape by wet etching and is required to be formed at a high temperature in order to obtain the ZnO layer 37 having a high crystallinity.

(comparative example 2)

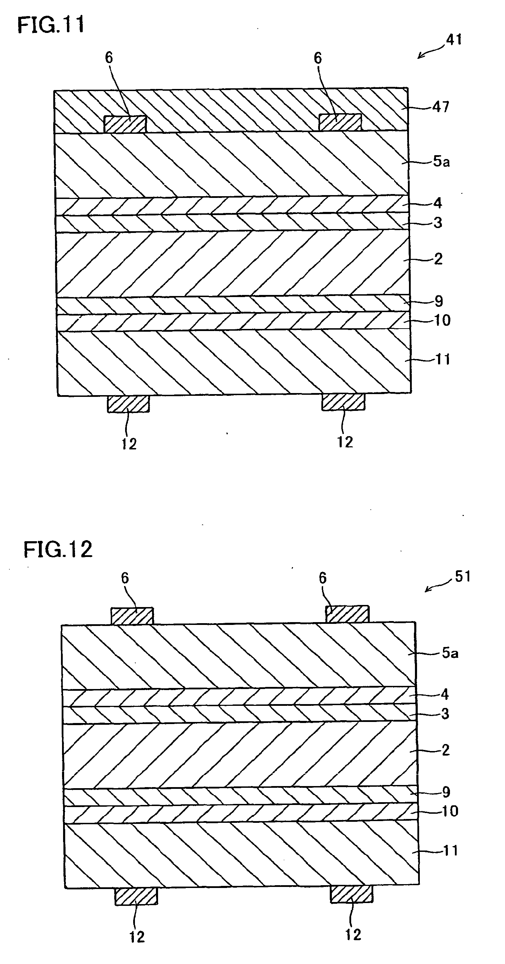

In this comparative example 2, formation was conducted until a back collector 12 of a photovoltaic device 41 shown in Fig. 11 was formed through a process similar to the process of the aforementioned embodiment. At this time, a transparent conductive film 5a was formed with a thickness of about 100 nm. Thereafter a MgF$_2$ layer 47 as an antireflection film having a thickness of about 100 nm was formed to cover the transparent conductive film 5a and front collector 6. Thus, the photovoltaic device 41 according to comparative example 2 was prepared.

(comparative example 3)

In this comparative example 3, formation was conducted until a back collector 12 of a photovoltaic device 51 shown in Fig. 12 was formed through a process similar to the process of the aforementioned embodiment. At this time, a transparent conductive film 5a was formed with a thickness of about 100 nm. Thus, the photovoltaic device 51 according to comparative example 3 was prepared. In this photovoltaic device 51 according to the comparative example 3, no layer is formed on upper surfaces of the transparent conductive film 5a and front collector 6.

Open-circuit voltages (Voc), short-circuit currents (Isc), cell outputs (Pmax) and fill factors (F.F.) of the photovoltaic devices 1, 31, 41 and 51 according to the aforementioned Example 1 and comparative examples 1 to 3 were measured respectively. Table 2 shows the results as follows. The open-circuit voltages (Voc), the short-circuit currents (Isc), the cell outputs (Pmax) and the fill factors (F.F.) in Example 1, and comparative examples 1 and 2 were normalized with reference to those of comparative example 3 ("1") in which no layer is formed on the upper surfaces of the transparent conductive film 5 and the front collector 6.

Table 2

|  | Normalized Open Circuit Voltage (Vcc) | Normalized Short Circuit Voltage (Isc) | Normalized Cell Output (Pmax) | Normalized Fill Factor (F.F.) |
|---|---|---|---|---|
| Example 1 | 1.001 | 1.053 | 1.053 | 0.999 |
| Comparative Example 1 | 0.996 | 1.021 | 1.018 | 1.001 |
| Comparative Example 2 | 0.999 | 1.032 | 1.032 | 1.001 |
| Comparative Example 3 | 1.000 | 1.000 | 1.000 | 1.000 |

Referring to the aforementioned Table 2, it has been proved that the open-circuit voltage (Voc) is larger in Example 1 including the ZnO layer 7 having the through holes 7a extending in the film thickness direction as compared with comparative examples 1 to 3 with no through holes 7a extending in the film thickness direction. It has been proved that the open-circuit voltage in comparative example 1 including the ZnO layer 37 formed at a formation temperature of 180°C and having the crater shaped surface for diffusing light is particularly small. More specifically, the normalized open-circuit voltage was 1.001 in Example 1 in which the ZnO layer 7 having the through holes 7a extending in the film thickness direction was formed. On the other hand, the normalized open-circuit voltage was 0.996 in comparative example 1 including the ZnO layer 37 formed at a formation temperature of 180°C and having the crater shaped surface for diffusing light. The normalized open-circuit voltage was 0.999 in comparative example 2 including the $MgF_2$ layer 47 as the antireflection film. Although not listed in Table 2, the open-circuit voltage was slightly reduced also in the photovoltaic device having the ZnO layer 7 of Example 1 formed not at room temperature but at 180°C.

It is conceivable from these results that the photovoltaic device 31 was damaged due to heat in forming the ZnO layer 37 and hence the open-circuit voltage was reduced in comparative example 1 including the ZnO layer 37 formed at a formation temperature of 180°C and having the crater shaped surface for diffusing light.

It has been proved that the short-circuit currents of comparative example 1 including the ZnO layer 37 formed at a formation temperature of 180°C and having the crater shaped surface for diffusing light and comparative example 2 including the $MgF_2$ layer 47 as the antireflection film are larger than that of comparative example 3 in which no layer is formed on the upper surfaces of the transparent conductive film 5a and the front collector 6. It has been proved that the short-circuit current of Example 1 including the ZnO layer 7 having the through holes 7a extending in the film thickness direction is larger than those of comparative example 1 including the ZnO layer 37 formed at a formation temperature of 180° C and having the crater shaped surface for diffusing light and comparative example 2 including the $MgF_2$ layer 47 as the antireflection film. More specifically, the normalized short-circuit current was 1.053 in Example 1 including the ZnO layer 7 having the through holes 7a extending in the film thickness direction. On the other hand, the normalized short-circuit current was 1.021 in comparative example 1 including the ZnO layer 37 formed at a formation temperature of 180° C and having the crater shaped surface for diffusing light, while the normalized short-circuit current was 1.032 in comparative example 2 including the $MgF_2$ layer 47 as the antireflection film.

It is conceivable from these results that, in comparative example 1 including the ZnO layer 37 formed at a formation temperature of 180° C and having the crater shaped surface for diffusing light, the light pass length of incident light in the n-type single-crystalline silicon substrate 2 (photoelectric conversion layer) can be increased due to the function of diffusing light with the crater shape of the surface of the ZnO layer 37, and hence the short-circuit current was larger than that of comparative example 3 in which no layer is formed on the upper surfaces of the transparent conductive film 5a and the front collector 6. It is conceivable that, in comparative example 2 including the $MgF_2$ layer 47 as the antireflection film, the $MgF_2$ layer 47 as the antireflection film formed on the surface upon which light is incident can inhibit light from reflecting and hence the short-circuit current was larger than that of the comparative example 3 in which no layer is formed on the upper surfaces of the transparent conductive film 5a and the front collector 6. It is conceivable that, in Example 1 including the ZnO layer 7 having the through holes 7a extending in the film thickness direction, the ZnO layer 7 having the through holes 7a extending in the film thickness direction and the silicon oxide film 8 were formed on the surfaces upon which light is incident, whereby light can be inhibited from reflecting while diffusing light, resulting in that the short-circuit current was larger than those of comparative example 1 having a function of diffusing light only and comparative example 2 having a function of inhibiting light from reflecting only.

A comparative experiment was conducted as to transmittance of a ZnO layer 7 having through holes 7a extending in a film thickness direction as in Example 1 and a ZnO layer 37 having a crater shaped surface as in comparative example 1, separately from the aforementioned experiment. First, the ZnO layer 7 having the through holes 7a extending in the film thickness direction as in Example 1 and the ZnO layer 37 having the crater shaped surface as in comparative example 1 were prepared so as to have the haze rates nearly equal to each other. Light transmittance were compared as to the ZnO layer 7 having the through holes 7a extending in the film thickness direction as in Example 1 and the ZnO layer 37 having the crater shaped surface as in comparative example 1. The experiment was conducted setting wavelength of incident light to 400 nm, 700nm and 1000 nm. It has been proved from the results that the transmittance of Example 1 including the ZnO layer 7 having the through holes 7a extending in the film thickness direction is larger than that of comparative example 1 including the ZnO layer 37 having the crater shaped surfaces by about 3.5 %, in wavelength of 400 nm, 700m, and 1000 nm. It is conceivable from these results that the photovoltaic device 1 according to Example 1 can increase the quantity of incident light reaching the n-type single-crystalline silicon substrate 2 as compared with the photovoltaic device 31 according to comparative example 1. Thus, it is conceivable that increase in the short-circuit current of the photovoltaic device 1 according to Example 1 was caused by increase in transmittance due to through holes 7a of the ZnO layer 7.

As shown in the aforementioned Table 2, it has been proved that the cell output is larger in Example 1 (normalized cell output: 1.053) including the ZnO layer 7 having the through holes 7a extending in the film thickness direction, as compared with comparative example 1 (normalized cell output: 1.018) including the ZnO layer 37 formed at a formation temperature of 180° C and having the crater shaped surface for diffusing light, comparative example 2 (normalized cell output: 1.032) including the $MgF_2$ layer 47 as the antireflection film, and comparative example 3 (normalized cell output: 1.000) in which no layer is formed on the upper surfaces of the transparent conductive film 5a and the front collector 6.

As shown in the aforementioned Table 2, it has been proved that the fill factor of Example 1 (normalized fill factor: 0.999) including the ZnO layer 7 having the through holes 7a extending in the film thickness direction is nearly equal to those of comparative example 1 (normalized fill factor: 1.001) including the ZnO layer 37 formed at a formation temperature of 180° C and having the crater shaped surface for diffusing light, comparative example 2 including the $MgF_2$ layer 47 as the antireflection film (normalized fill factor: 1.001), and comparative example 3 (normalized fill factor: 1.000) in which no layer is formed on the upper surfaces of the transparent conductive film 5a and the front collector 6.

An experiment investigating humidity resistance in the photovoltaic module will be now described. In this experiment, a photovoltaic module 21 according to Example 2 corresponding to this embodiment and photovoltaic modules 61 and 71 according to comparative examples 4 and 5 were prepared. The photovoltaic device 1 according to the aforementioned Example 1 was used for preparing the photovoltaic module 21 according to Example 2, while the photovoltaic device 31 according to the aforementioned comparative example 1 was used for preparing the photovoltaic module 61 according to comparative example 4. The photovoltaic device 41 according to the aforementioned comparative example 2 was used for preparing the photovoltaic module 71 according to comparative example 5.

(Common to Example 2 and Comparative Examples 4 and 5)

First, a plurality of the photovoltaic devices 1 (31, 41) according to the aforementioned Example 1 and comparative examples 1 and 2 were prepared. Thereafter each of the plurality of photovoltaic devices 1 (31, 41) was connected to the adjacent photovoltaic device 1 (31, 41) through a tab electrode 22 of copper foil as shown in Fig. 3.

Then an EVA sheet for forming a filler 23, the plurality of photovoltaic devices 1 (31, 41) connected to each other through the tab electrodes 22, another EVA sheet for forming the filler 23, and a back surface protector 25 consisting of PVF having a thickness of about 25 μm were successively stacked on a front surface protector 24 consisting of a glass substrate. Thereafter a photovoltaic module 21 (61, 71) including the plurality of photovoltaic devices 1 (31, 41) was formed by performing a vacuum laminating process while heating.

The photovoltaic modules 21, 61 and 71 according to the aforementioned Example 2 and comparative examples 4 and 5 were left under a high humidity condition for 2000 hours. Then an investigation was conducted as to whether peeling between the filler 23 and the photovoltaic devices 1, 31, and 41 occurred. Table 3 shows the results.

Table 3

|  | Presence or Absence of Peeling |
|---|---|
| Example 2 | ○ (No Peeling Occurred) |
| Comparative Example 4 | × (Peeling Occurred) |
| Comparative Example 5 | × (Peeling Occurred) |

Referring to the aforementioned Table 3, it has been proved that peeling does not occur between the filler 23 and the photovoltaic devices 1 in the photovoltaic module 21 according to Example 2 including the ZnO layer 7 having the through holes 7a in the film thickness direction. It has been proved that peeling partially occurs between the filler 23 and upper surfaces of the photovoltaic devices 31 and 41 in the photovoltaic module 61 according to comparative example 4 including the ZnO layer 37 having the crater shaped surface and the photovoltaic module 71 according to comparative example 5 including the $MgF_2$ layer 47 as the antireflection film respectively.

It is conceivable from these results that, in the photovoltaic module 21 of Example 2 including the ZnO layer 7 having the through holes 7a, the filler 23 enters into the through holes 7a of the ZnO layer 7 as shown in Fig. 4, whereby anchor effect between the filler 23 and the photovoltaic devices 1 are increased, thereby increasing a junction strength between the filler 23 and the photovoltaic devices 1.

An embodiment and Examples disclosed this time must be considered as illustrative and not restrictive in all points. The range of the present invention is shown not by the above description of the embodiment and Examples but by the scope of claim, and all modifications within the meaning and range equivalent to the scope of claim are further included.

For example, while the ZnO layer is employed as the first layer having the holes (through holes) extending in the film thickness direction in the aforementioned embodiment, the present invention is not restricted to this but any layer constituted by the translucent material other than the ZnO layer may be alternatively employed so far as the layer has holes (through holes) extending in the film thickness direction.

While the examples employing the silicon oxide film 8 of $SiO_2$ having the etching rate smaller than the etching rate of the ZnO layer with respect to the etching solution (HCl (about 0.5 mass %)) as the upper layer of the ZnO layer have been shown in the aforementioned embodiment, the present invention is not restricted to this but a layer of $TiO_2$, $SiO_n$, SiON, SiN, $Al_2O_3$ or ITO (Indium Tin Oxide) or the like having an etching rate smaller than the ZnO layer may be alternatively employed as the upper layer of the ZnO layer.

While the structure in which the silicon oxide film formed on the ZnO layer is left has been shown in the aforementioned embodiment, the present invention is not restricted to this but the silicon oxide film may be removed after forming the through holes in the ZnO layer.

While the examples employing the n-type single-crystalline silicon substrate as the photoelectric conversion layer have been shown in the aforementioned embodiment, the present invention is not restricted to this but a p-type single-crystalline silicon substrate may be alternatively employed as the photoelectric conversion layer or an n-type or p-type amorphous silicon substrate may be employed.

While the examples in which the ZnO layer having the through holes extending in the film thickness direction was formed on the transparent conductive film formed on the upper surface of the semiconductor layer have been shown in the aforementioned embodiment, the present invention is not restricted to this but the through holes extending in the film thickness direction may be formed in the transparent conductive film formed on the upper surface of the semiconductor layer without providing the ZnO layer. In this case, the through holes extending in the film thickness direction may be formed in the transparent conductive film by etching using a mask.

While the through holes formed in the film thickness direction has been shown as the holes formed in the first layer in the aforementioned embodiment, the present invention is not restricted to this but the holes formed in the first layer may not be through holes so far as the holes extend in the film thickness direction.

While the examples in which the ZnO layer is provided as the non-doped layer have been shown in the aforementioned embodiment, the present invention is not restricted to this but the ZnO layer may be alternatively doped with Al or Ga.

**Claims**

**1.** A photovoltaic device (1) comprising:

a semiconductor layer (2 to 4, 9, 10) including a photoelectric conversion layer (2); and

a first layer (7) constituted by a translucent material, formed on said semiconductor layer
**characterised in that**:

the first layer (7) has a plurality of first holes (7a) arranged in a dispersed manner on an upper surface of the semiconductor layer and extending in a film thickness direction from a light incident surface of the first layer (7) towards the semiconductor layer,
wherein an inner diameter of each first hole (7a) is not more than 1.2 $\mu$m .

2. The photovoltaic device according to claim 1, further comprising a collector (6) formed on said semiconductor layer, wherein said first layer is so formed as to cover said collector and constituted by a translucent material having electrical conductivity.

3. The photovoltaic device according to claim 1 or 2, wherein said first layer constituted by said translucent material is a ZnO layer having said first hole extending in said film thickness direction.

4. The photovoltaic device according to any one of claims 1 to 3, wherein a plurality of said first holes of said first layer are provided to penetrate said first layer in the film thickness direction.

5. The photovoltaic device according to any one of claims 1 to 4, further comprising a second layer (8) constituted by a translucent material, formed on said first layer constituted by said translucent material, and having a second hole (8a) on a portion corresponding to said first hole of said first layer, wherein the etching rate of said second layer with respect to prescribed etching solution is smaller than the etching rate of said first layer with respect to said prescribed etching solution.

6. The photovoltaic device according to claim 5, wherein said second layer consists of a Si compound including at least one of O and N.

7. A method for manufacturing a photovoltaic device (1), comprising steps of:

forming a first layer (7) constituted by a translucent material on a semiconductor layer (2-4, 9, 10) including a photoelectric conversion layer (2),
forming a second layer (8) constituted by a translucent material, having an etching rate smaller than the etching rate of said first layer with respect to prescribed etching solution and having a crystal grain boundary (8b), on said first layer; and
forming a first hole (7a) that continues from a second hole (8a), the first hole (7a) and the second hole (8a) extending in a film thickness direction on portions corresponding to said crystal grain boundary of said second layer in said first layer and said second layer by etching from a surface of said second layer towards the semiconductor layer with said prescribed etching solution respectively,
**characterised in that**:

an inner diameter of the first hole (7a) is not more than 1.2 $\mu$m.

8. The method for manufacturing a photovoltaic device according to claim 7, further comprising a step of forming a collector (6) on said semiconductor layer prior to said step of forming said first layer on said semiconductor layer, wherein said step of forming said first layer on said semiconductor layer includes a step of forming said first layer constituted by a translucent material having electrical conductivity to cover said collector.

9. The method for manufacturing a photovoltaic device according to claim 7 or 8, wherein said first layer constituted by said translucent material is a ZnO layer having said first hole extending in said film thickness direction.

10. The method for manufacturing a photovoltaic device according to any one of claims 7 to 9, wherein said step of forming said first hole and said second hole extending in said film thickness direction includes a step of providing a plurality of said first hole penetrating said first layer in said film thickness direction.

11. The method for manufacturing a photovoltaic device according to any one of claims 7 to 10, wherein said second layer consists of a Si compound including at least one of O and N.

**Patentansprüche**

1. Photovoltaikvorrichtung (1), die Folgendes umfasst:

   eine Halbleiterschicht (2 bis 4, 9, 10), die eine photoelektrische Umwandlungsschicht (2) und eine erste Schicht (7) aus einem lichtdurchlässigen Material umfasst, die auf der Halbleiterschicht ausgebildet ist, **dadurch gekennzeichnet, dass**:

   die erste Schicht (7) eine Vielzahl erster Löcher (7a) aufweist, die verteilt auf einer oberen Oberfläche der Halbleiterschicht angeordnet sind und sich in Filmdickerichtung von einer Lichteinfallsoberfläche der ersten Schicht (7) in Richtung der Halbleiterschicht erstrecken, wobei der Innendurchmesser jedes der ersten Löcher (7a) nicht mehr als 1,2 $\mu$m beträgt.

2. Photovoltaikvorrichtung nach Anspruch 1, die ferner einen Kollektor (6) umfasst, der auf der Halbleiterschicht ausgebildet ist, wobei die erste Schicht so ausgebildet ist, dass sie den Kollektor bedeckt und aus einem lichtdurchlässigen Material besteht, das elektrische Leitfähigkeit aufweist.

3. Photovoltaikvorrichtung nach Anspruch 1 oder 2, worin die erste Schicht aus dem lichtdurchlässigen Material eine ZnO-Schicht ist, die das erste Loch aufweist, das sich in Filmdickerichtung erstreckt.

4. Photovoltaikvorrichtung nach einem der Ansprüche 1 bis 3, worin eine Vielzahl der ersten Löcher der ersten Schicht bereitgestellt ist, um die erste Schicht in Filmdickerichtung zu durchdringen.

5. Photovoltaikvorrichtung nach einem der Ansprüche 1 bis 4, die ferner eine zweite Schicht (8) aus einem lichtdurchlässigen Material umfasst, die auf der ersten Schicht aus dem lichtdurchlässigen Material ausgebildet ist und ein zweites Loch (8a) in einem Abschnitt aufweist, der dem ersten Loch der ersten Schicht entspricht, wobei die Ätzrate der zweiten Schicht in Bezug auf die vorgeschriebene Ätzlösung geringer ist als die Ätzrate der ersten Schicht in Bezug auf die vorgeschriebene Ätzlösung.

6. Photovoltaikvorrichtung nach Anspruch 5, worin die zweite Schicht aus einer Si-Verbindung, die zumindest ein Element ausgewählt aus O und N umfasst, besteht.

7. Verfahren zur Herstellung einer Photovoltaikvorrichtung (1), das folgende Schritte umfasst:

   das Ausbilden einer ersten Schicht (7) aus einem lichtdurchlässigen Material auf einer Halbleiterschicht (2-4, 9, 10), die eine photoelektrische Umwandlungsschicht (2) umfasst, das Ausbilden einer zweiten Schicht (8) aus einem lichtdurchlässigen Material mit einer Ätzrate, die in Bezug auf eine vorgeschriebene Ätzlösung geringer ist als die Ätzrate der ersten Schicht, und mit einer Kristallkorngrenze (8b) auf der ersten Schicht und das Ausbilden eines ersten Lochs (7a), das ein zweites Loch (8a) fortsetzt, wobei sich das erste Loch (7a) und das zweite Loch (8a) in Filmdickerichtung in Abschnitten erstrecken, die der Kristallkorngrenze der zweiten Schicht in der ersten und zweiten Schicht entsprechen, durch das Ätzen von einer Oberfläche der zweiten Schicht in Richtung der Halbleiterschicht unter Verwendung der vorgeschriebenen Ätzlösung, **dadurch gekennzeichnet, dass**:

   der Innendurchmesser des ersten Lochs (7a) nicht mehr als 1,2 $\mu$m beträgt.

8. Verfahren zur Herstellung einer Photovoltaikvorrichtung nach Anspruch 7, das ferner einen Schritt des Ausbildens eines Kollektors (6) auf der Halbleiterschicht vor dem Schritt des Ausbildens der ersten Schicht auf der Halbleiterschicht umfasst, wobei der Schritt des Ausbildens der ersten Schicht auf der Halbleiterschicht einen Schritt des Ausbildens der ersten Schicht aus einem lichtdurchlässigen Material mit elektrischer Leitfähigkeit umfasst, so dass diese den Kollektor bedeckt.

9. Verfahren zur Herstellung einer Photovoltaikvorrichtung nach Anspruch 7 oder 8, worin die erste Schicht aus dem lichtdurchlässigen Material eine ZnO-Schicht ist, wobei sich das erste Loch in Filmdickerichtung erstreckt.

10. Verfahren zur Herstellung einer Photovoltaikvorrichtung nach einem der Ansprüche 7 bis 9, worin der Schritt des Ausbildens des ersten Lochs und des zweiten Lochs, die sich in Filmdickerichtung erstrecken, einen Schritt des Bereitstellens einer Vielzahl erster Löcher umfasst, die die erste Schicht in Filmdickerichtung durchdringen.

11. Verfahren zur Herstellung einer Photovoltaikvorrichtung nach einem der Ansprüche 7 bis 10, worin die zweite Schicht aus einer Si-Verbindung besteht, die zumindest ein Element ausgewählt aus O und N umfasst.

**Revendications**

1. Dispositif photovoltaïque (1) comprenant :

   une couche semi-conductrice (2 à 4, 9, 10) comprenant une couche de conversion photoélectrique (2) ; et
   une première couche (7) constituée par un matériau translucide, formée sur ladite couche semi-conductrice, caractérisé en ce qui :

      la première couche (7) comporte une pluralité de premiers trous (7a) agencés d'une manière dispersée sur une surface supérieure de la couche semi-conductrice et s'étendant dans une direction d'épaisseur de film d'une surface d'incidence de lumière de la première couche (7) vers la couche semi-conductrice, dans lequel un diamètre interne de chaque premier trou (7a) n'est pas supérieur à 1,2 $\mu$m.

2. Dispositif photovoltaïque selon la revendication 1, comprenant en outre un collecteur (6) formé sur ladite couche semi-conductrice, dans lequel ladite première couche est formée de manière à recouvrir ledit collecteur et constituée par un matériau translucide ayant une conductivité électrique.

3. Dispositif photovoltaïque selon la revendication 1 ou 2, dans lequel ladite première couche constituée par ledit matériau translucide est une couche de ZnO comportant ledit premier trou s'étendant dans ladite direction d'épaisseur de film.

4. Dispositif photovoltaïque selon l'une quelconque des revendications 1 à 3, dans lequel une pluralité desdits premiers trous de ladite première couche sont réalisés pour pénétrer dans ladite première couche dans la direction d'épaisseur de film.

5. Dispositif photovoltaïque selon l'une quelconque des revendications 1 à 4, comprenant en outre une deuxième couche (8) constituée par un matériau translucide, formée sur ladite première couche constituée par ledit matériau translucide, et comportant un deuxième trou (8a) sur une partie correspondant au dit premier trou de ladite première couche, dans lequel la vitesse de gravure de ladite deuxième couche en relation avec une solution de gravure prescrite est inférieure à la vitesse de gravure de ladite première couche en relation avec ladite solution de gravure prescrite.

6. Dispositif photovoltaïque selon la revendication 5, dans lequel ladite deuxième couche consiste en un composé de Si comprenant au moins l'un de 0 et N.

7. Procédé de fabrication d'un dispositif photovoltaïque (1), comprenant les étapes :

   de formation d'une première couche (7) constituée par un matériau translucide sur une couche semi-conductrice (2 à 4, 9, 10) comprenant une couche de conversion photoélectrique (2),
   de formation d'une deuxième couche (8) constituée par un matériau translucide, ayant une vitesse de gravure inférieure à la vitesse de gravure de ladite première couche en relation avec une solution de gravure prescrite et ayant une frontière de grains cristallins (8b), sur ladite première couche ; et
   de formation d'un premier trou (7a) qui prolonge un deuxième trou (8a), le premier trou (7a) et le deuxième trou (8a) s'étendant dans une direction d'épaisseur de film sur des parties correspondant à ladite frontière de grains cristallins de ladite deuxième couche dans ladite première couche et ladite deuxième couche en gravant d'une surface de ladite deuxième couche vers la couche semi-conductrice avec ladite solution de gravure prescrite, respectivement,
   **caractérisé en ce que** :

      un diamètre intérieur du premier trou (7a) n'est pas supérieur à 1,2 $\mu$m.

8. Procédé de fabrication d'un dispositif photovoltaïque selon la revendication 7, comprenant en outre une étape de formation d'un collecteur (6) sur ladite couche semi-conductrice avant ladite étape de formation de ladite première couche sur ladite couche semi-conductrice,

dans lequel ladite étape de formation de ladite première couche sur ladite couche semi-conductrice comprend une étape de formation de ladite première couche constituée par un matériau translucide ayant une conductivité électrique pour recouvrir ledit collecteur.

9. Procédé de fabrication d'un dispositif photovoltaïque selon la revendication 7 ou 8, dans lequel ladite première couche constituée par ledit matériau translucide est une couche de ZnO comportant ledit premier trou s'étendant dans ladite direction d'épaisseur de film.

10. Procédé de fabrication d'un dispositif photovoltaïque selon l'une quelconque des revendications 7 à 9, dans lequel ladite étape de formation dudit premier trou et dudit deuxième trou s'étendant dans ladite direction d'épaisseur de film comprend une étape de réalisation d'une pluralité desdits premiers trous pénétrant dans ladite première couche dans ladite direction d'épaisseur de film.

11. Procédé de fabrication d'un dispositif photovoltaïque selon l'une quelconque des revendications 7 à 10, dans lequel ladite deuxième couche consiste en un composé de Si comprenant au moins l'un de 0 et N.

FIG.1

FIG.2

**FIG.3**

**FIG.4**

FIG.5

FIG.6

FIG.7

FIG.8

FIG.9

FIG.10

FIG.11

FIG.12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 51117591 A
- JP 6204544 A
- JP 6204541 A
- JP 2000294812 A
- JP 2001156317 A
- JP 2143569 A
- JP 6116996 A